# EUROPEAN PATENT APPLICATION

(11) **EP 3 208 805 A1**
(43) Date of publication of application: **23.08.2017**
(21) Application number: 17150645.4
(22) Date of filing: 09.01.2017
(51) Int. Cl.: G11C 11/4093, G11C 11/4076, G11C 7/22, G11C 7/10, G11C 5/04, G06F 13/40, H04L 25/02, H03K 19/00

(54) **TERMINATION TOPOLOGY OF MEMORY SYSTEM AND ASSOCIATED MEMORY MODULE AND CONTROL METHOD**

(30) Priority: 22.02.2016 US 201662298005 P; 26.12.2016 US 201615390692
(71) Applicant: MediaTek Inc., Hsin-Chu 300 (TW)
(72) Inventor: CHEN, Shang-Pin, 302 Zhubei City Hsinchu County (TW)
(74) Representative: Hoefer & Partner Patentanwälte mbB

(57) **Abstract**

A memory system (100) includes a memory controller (1 10) and a memory module (120), where the memory controller (110) is arranged for generating at least a first clock signal (WCK) and an inverted first clock signal (WCKB), and the memory module (120) is arranged to receive at least the first clock signal (WCK) and the inverted first clock signal (WCKB) from the memory controller (110). In addition, the memory module (120) includes a termination module (ODT1, ODT2), and the first clock signal (WCK) is coupled to the inverted first clock signal (WCKB) through the termination module.

## Description

### Background

A conventional dynamic random access memory (DRAM) module generally includes on-die termination for impedance matching of signal lines, and signal distortion can be reduced by using the on-die termination. The conventional on-die termination is generally connected to a reference voltage such as a ground voltage, however, this design is not able to optimize the signal quality.

### Summary

It is therefore an objective of the present invention to provide an on-die termination topology, which can improve the signal quality more, to solve the above-mentioned problem.

This is achieved by a memory system according to claim 1, a memory module according to claim 7, and a control method of a memory module according to claim 12. The dependent claims pertain to corresponding further developments and improvements.

As will be seen more clearly from the detailed description following below, a memory system comprises a memory controller and a memory module, where the memory controller is arranged for generating at least a first clock signal and an inverted first clock signal, and the memory module is arranged to receive at least the first clock signal and the inverted first clock signal from the memory controller. In addition, the memory module comprises a termination module, and the first clock signal is coupled to the inverted clock signal through the termination module.

As will be seen more clearly from the detailed description following below, a memory module comprises a memory interface circuit and a first termination module, wherein the memory interface circuit is arranged for receives at least a first clock signal and an inverted first clock signal from a memory controller, and the first clock signal is coupled to the inverted first clock signal through the first termination module.

As will be seen more clearly from the detailed description following below, a control method of a memory module, wherein the memory module comprises a termination module, and the control method comprises: receiving a clock signal and an inverted clock signal from a memory controller; and coupling the clock signal to the inverted clock signal through the termination module within the memory module.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a memory system according to one embodiment of the present invention.
FIG. 2 is a diagram illustrating on-die termination design of the memory system according to one embodiment of the present invention.
FIG. 3 is a diagram illustrating on-die termination design of the memory system according to another embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ..." The terms "couple" and "couples" are intended to mean either an indirect or a direct electrical connection. Thus, if a first device couples to a second device, that connection may be through a direct electrical connection, or through an indirect electrical connection via other devices and connections.

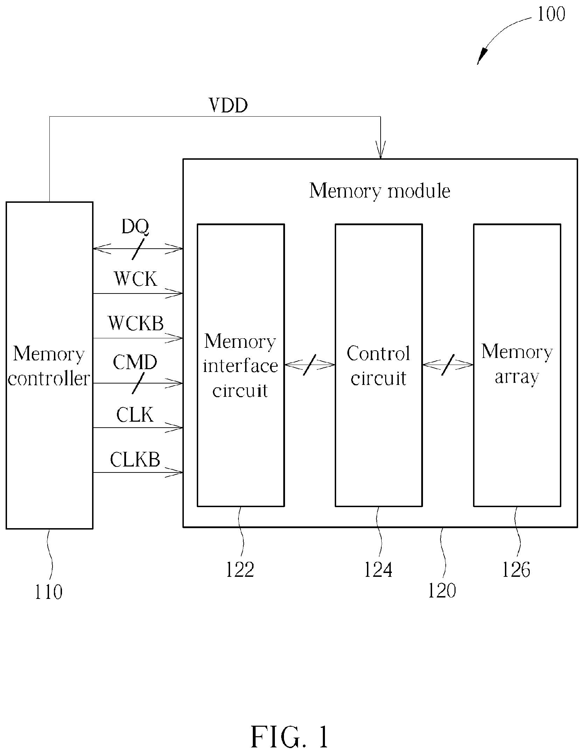

Please refer to FIG. 1, which is a diagram illustrating a memory system 100 according to one embodiment of the present invention. As shown in FIG. 1, the memory system 100 comprises a memory controller 110 and a memory module 1 20 supplied by a supply voltage VDD, where the memory module 120 comprises a memory interface circuit 122, a control circuit 124 and a memory array 126. In this embodiment, the memory controller 110 and the memory module 120 are connected via a plurality of connection lines, where the connection lines are used to transmit a plurality of bi-directional data signals DQs, a write clock signal WCK, an inverted write clock signal WCKB, a plurality of command signals CMDs, a clock signal CLK, and an inverted clock signal CKB. In one embodiment, the memory system 100 is a volatile memory system such as a DRAM system, the memory controller 110 is the DRAM memory controller, and the memory module 1 20 is a DRAM memory module.

When the memory system 100 is implemented by the DRAM system the command signals may comprise at least a row address strobe, a column address strobe, and a write enable signal. In addition, the write clock signal WCK and the inverted write clock signal WCKB are arranged for a data signal (DQs) latch in the memory module 120, and the clock signal CLK and the inverted clock signal CLKB are arranged for a command signal (CMDs) latch in the memory module 120, and a frequency of the write clock signal WCK is greater than or equal to a frequency of the clock signal CLK. For example, the memory module 120 may use the write clock signal WCK and the inverted write clock signal WCKB to sample and store the data signal for subsequent signal processing, and the memory module 120 may use the clock signal CLK and the inverted clock signal CLKB to sample and store the command signal for subsequent signal processing.

In the operations of the memory system 100, the memory controller 110 is arranged to receive a request from a host or a processor, and to transmit at least a portion of the data signal DQ, command signals CMDs, the clock signal CLK, the inverted clock signal CLKB, the write clock signal WCK and the inverted write clock signal WCKB to access the memory module 120. In addition, the memory controller 110 may comprise associated circuits, such as an address decoder, a processing circuit, a write/read buffer, a control logic and an arbiter, to perform the related operations. The memory interface circuit 122 comprises a plurality of pads/pins and associated receiving circuit, and the memory interface circuit 122 is arranged to receive the data signal DQs, the write clock signal WCK, the inverted write clock signal WCKB, the command signals CMDs, the clock signal CLK, and the inverted clock signal CLKB from the memory controller 110, and to selectively output the received signals to the control circuit 124. The control circuit 1 24 may comprise a read/write controller, a row decoder and a column decoder, and the control circuit 124 is arranged to receive the signals from the memory interface circuit 122 to access the memory array 126.

Because the embodiments of the present invention focus on the connections of the on-die termination, detailed descriptions about the other elements are therefore omitted here.

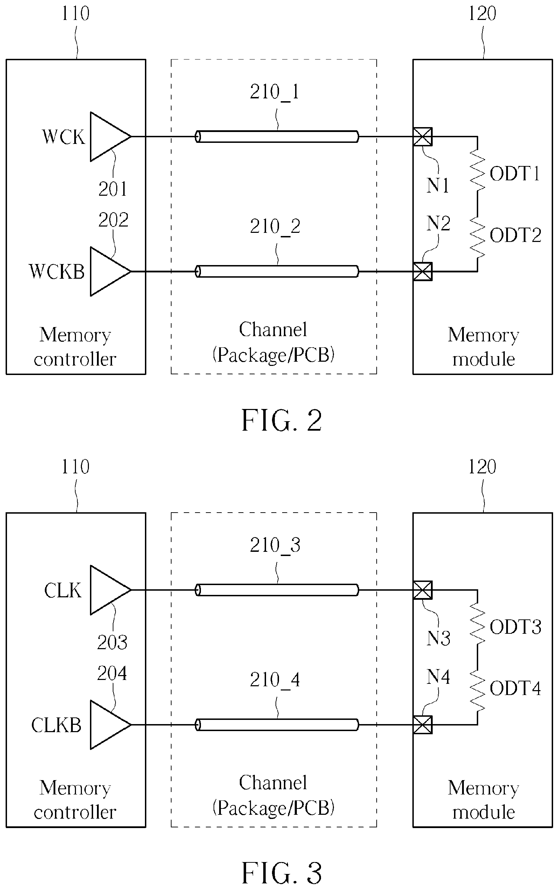

Please refer to FIG. 2, which is a diagram illustrating on-die termination design of the memory system 100 according to one embodiment of the present invention. As shown in FIG. 2, the memory module 1 20 comprises two termination resistors ODT1 and ODT2, and the two termination resistors ODT1 and ODT2 are connected to each other to allow the write clock signal WCK to connect to the inverted write clock signal WCKB on die. In this embodiment, the two termination resistors ODT1 and ODT2 can be implemented by metal-oxide semiconductor (MOS), metal wire, poly silicon or any other suitable resistors whose resistance is capable of being calibrated/adjusted, and the two termination resistors ODT1 and ODT2 are not connecting to any bias voltage such as a ground voltage or a supply voltage. In detail, when the write clock signal WCK is at a high voltage level and the inverted write clock signal WCKB is at a low voltage level, a current flows from a driver 201, a channel 210_1, a pad N1, the two termination resistors ODT1 and ODT2, a pad N2, a channel 210_2 to a driver 202; and when the write clock signal WCK is at low voltage level and the inverted write clock signal WCKB is at the high voltage level, a current flows from the driver 202, the channel 210_2, the pad N2, the two termination resistors ODT1 and ODT2, the pad N1, the channel 210_1 to the driver 201. In this embodiment, the channels 210_1 and 210_2 may be the transmission lines on a package or a printed circuit board (PCB).

In addition, a quantity of the termination resistors shown in FIG. 2 is for illustrative purposes only, not a limitation to the present invention. As long as the memory module 120 has at least one termination resistor for allowing the write clock signal WCK to connect to the inverted write clock signal WCKB, the quantity of the termination resistors within the memory module 120 can be determined in compliance with design requirement.

By using the on-die termination design shown in FIG. 2, the impedance matching can be more accurate, and the reflection of the signal can be lowered to improve the signal integrity.

FIG. 2 shows that the memory module 120 comprises two termination resistors ODTs for connecting the write clock signal WCK to the inverted write clock signal WCKB. In another embodiment, the memory module 120 may further comprise other termination resistors ODTs for connecting the clock signal CLK to the inverted clock signal CLKB. Please refer to FIG. 3, the memory module 120 further comprises termination resistors ODT3 and ODT4, and the termination resistors ODT3 and ODT4 are connected to each other to allow the clock signal CLK to connect to the inverted clock signal CLKB. In this embodiment, the termination resistors ODT3 and ODT4 can be implemented by MOS, metal wire, poly silicon or any other suitable resistors whose resistance is capable of being calibrated/adjusted, and the termination resistors ODT3 and ODT4 are not connecting to any bias voltage such as a ground voltage or a supply voltage. In detail, when the clock signal CLK is at a high voltage level and the inverted clock signal CLKB is at a low voltage level, a current flows from a driver 203, a channel 210_3, a pad N3, the two termination resistors ODT3 and ODT4, a pad N4, a channel 210_4 to a driver 204; and when the clock signal CLK is at the low voltage level and the inverted clock signal CLKB is at the high voltage level, a current flows from the driver 204 the channel 210_4, the pad N4, the two termination resistors ODT3 and ODT4, the pad N3, the channel 210_3 to the driver 203. In this embodiment, the channels 210_3 and 210_4 may be the transmission lines on the package or the PCB.

In addition, a quantity of the termination resistors shown in FIG. 3 is for illustrative purposes only, not a limitation of the present invention. As long as the memory module 120 has at least one termination resistor for allowing the clock signal CLK to connect to the inverted clock signal CLKB, the quantity of the termination resistors within the memory module 120 can be determined according to designer's consideration.

Briefly summarized, in the on-die termination topology of the present invention, the clock signal is allowed to connect the inverted clock signal in die. Therefore, the impedance matching can be more accurate, and the reflection of the signal can be lowered to improve the signal integrity.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A memory system (100), comprising:
a memory controller (110), for generating at least a first clock signal (WCK, CLK) and an inverted first clock signal (WCKB, CLKB);
**characterized by**:
a memory module (120), coupled to the memory controller (110), wherein the memory module receives at least the first clock signal (WCK, CLK) and the inverted first clock signal (WCKB, CLKB) from the memory controller (110), and the memory module (1 20) comprises:
a first termination module (ODT1, ODT2; ODT3, ODT4), wherein the first clock signal (WCK, CLK) is coupled to the inverted first clock signal (WCKB, CLKB) through the first termination module (ODT1, ODT2; ODT3, ODT4).

2. The memory system (100) of claim 1, **characterized in that** the memory module (120) receives the first clock signal (WCK, CLK) and the inverted first clock signal (WCKB, CLKB) at two pads (N1, N2; N3, N4) of the memory module (120), respectively, and the first termination module (ODT1, ODT2; ODT3, ODT4) comprises a current path between the two pads (N1, N2; N3, N4) within the memory module (1 20).

3. The memory system (100) of claim 1, **characterized in that** the first termination module (ODT1, ODT2; ODT3, ODT4) comprises:
a first termination resistor (ODT1, ODT3), wherein a first node of the first termination resistor (ODT1, ODT3) is to receive the first clock signal (WCK, CLK); and
a second termination resistor (ODT2, ODT4), wherein a first node of the second termination resistor (ODT2, ODT4) is to receive the inverted first clock signal (WCKB, CLKB), and the a second node of the second termination resistor (ODT2, ODT4) is coupled to a second node of the first termination resistor (ODT1, ODT3).

4. The memory system (100) of claim 1, **characterized in that** the memory system (100) is a dynamic random access memory (DRAM) system, the first termination resistor module (ODT1, ODT2; ODT3, ODT4) is an on-die termination, and the first clock signal (WCK, CLK) is for data signal latch or command signal latch within the memory module (1 20).

5. The memory system (100) of claim 1, **characterized in that** the memory module (120) further generates a second clock signal (CLK) and an inverted second clock signal (CLKB), and the memory module (120) further receives the second clock signal (CLK) and the inverted second clock signal (CLKB) from the memory controller (110), and the memory module (120) further comprises:
a second termination module (ODT3, ODT4), wherein the second clock signal (CLK) is coupled to the inverted second clock signal (CLKB) through the second termination resistor module (ODT3, ODT4).

6. The memory system (100) of claim 5, **characterized in that** the memory system (100) is a dynamic random access memory (DRAM) system, each of the first termination module (ODT1, ODT2) and the second termination module (ODT3, ODT4) is an on-die termination, the first clock signal (WCK) is for data signal latch within the memory module (120), and the second clock signal (CLK) is for command signal latch within the memory module (120).

7. A memory module (1 20), comprising:
a memory interface circuit (122), for receiving at least a first clock signal (WCK, CLK) and an inverted first clock signal (WCKB, CLKB) from a memory controller (110);
**characterized by**:
a first termination module (ODT1, ODT2; ODT3, ODT4), coupled to the memory interface circuit (122), wherein the first clock signal (WCK, CLK) is coupled to the inverted first clock signal (WCKB, CLKB) through the first termination module (ODT1, ODT2; ODT3, ODT4).

8. The memory module (120) of claim 7, **characterized in that** the memory interface circuit comprises two pads (N1, N2; N3, N4) for receiving the first clock signal (WCK, CLK) and the inverted first clock signal (WCKB, CLKB), respectively, and the first termination module (ODT1, ODT2; ODT3, ODT4) builds a current path between the two pads (N1, N2; N3, N4).

9. The memory module (120) of claim 7, **characterized in that** the first termination module (ODT1, ODT2; ODT3, ODT4) comprises:
a first termination resistor (ODT1, ODT3), wherein a first node of the first termination resistor (ODT1, ODT3) is to receive the first clock signal (WCK, CLK); and
a second termination resistor (ODT2, ODT4), wherein a first node of the second termination resistor (ODT2, ODT4) is to receive the inverted first clock signal (WCKB, CLKB), and the a second node of the second termination resistor (ODT2, ODT4) is coupled to a second node of the first termination resistor (ODT1, ODT3).

10. The memory module (120) of claim 7, **characterized in that** the memory interface circuit (120) further receives a second clock signal (CLK) and an inverted second clock signal (CLKB) from the memory controller (110), and the memory module (120) further comprises:
a second termination module (ODT3, ODT4), wherein the second clock signal (CLK) is coupled to the inverted second clock signal (CLKB) through the second termination module (ODT3, ODT4).

11. The memory module (120) of claim 10, **characterized in that** the memory module (1 20) is a dynamic random access memory (DRAM) memory module, each of the first termination module (ODT1, ODT2) and the second termination module (ODT3, ODT4) is an on-die termination, the first clock signal (WCK) is for data signal latch within the memory module (120), and the second clock signal (CLK) is for command signal latch within the memory module (120).

12. A control method of a memory module (120), wherein the memory module (120) comprises a termination module (ODT1, ODT2; ODT3, ODT4), **characterized by** the control method comprises the steps of:
receiving a clock signal (WCK, CLK) and an inverted clock signal (WCKB, CLKB) from a memory controller (110); and
coupling the clock signal (WCK, CLK) to the inverted clock signal(WCKB, CLKB) through the termination module (ODT1, ODT2; ODT3, ODT4) within the memory module (1 20).

13. The control method of claim 12, **characterized in that** the memory module (120) receives the clock signal (WCK, CLK) and the inverted clock signal (WCKB, CLKB) at two pads (N1, N2; N3, N4) of the memory module (120), respectively, and the step of coupling the clock signal (WCK, CLK) to the inverted clock signal (WCKB, CLKB) through the termination module (ODT1, ODT2; ODT3, ODT4) comprises:
coupling the clock signal (WCK, CLK) to the inverted clock signal (WCKB, CLKB) through the termination module (ODT1, ODT2; ODT3, ODT4) to build a current path between the two pads (N1, N2; N3, N4).

14. The control method of claim 12, **characterized in that** the termination module (ODT1, ODT2; ODT3, ODT4) comprises a first termination resistor (ODT1, ODT3) and a second termination resistor (ODT2, ODT4), a first node of the first termination resistor (ODT1, ODT3) is to receive the clock signal (WCK, CLK), and a first node of the second termination resistor (ODT2, ODT4) is to receive the inverted clock signal (WCKB, CLKB), and the step of coupling the clock signal (WCK, CLK) to the inverted clock signal (WCKB, CLKB) through the termination module (ODT1, ODT2; ODT3, ODT4) comprises:
coupling a second node of the second termination resistor (ODT2, ODT4) to a second node of the first termination resistor (ODT1, ODT3).

15. The control method of claim 12, **characterized in that** the memory module (120) is a dynamic random access memory (DRAM) memory module, and the termination module (ODT1, ODT2; ODT3, ODT4) is an on-die termination.
